# EUROPÄISCHE PATENTSCHRIFT

(11) **EP 4 033 867 B1**
(45) Veröffentlichungstag und Bekanntmachung des Hinweises auf die Patenterteilung: **26.02.2025**
(21) Anmeldenummer: 21212660.1
(22) Anmeldetag: 07.12.2021
(51) Int. Cl.: G06T 7/00, G06T 7/11, G06T 15/08, H05K 1/02, B60R 16/03

(54) **ELEKTRISCHE SCHALTVORRICHTUNG**
ELECTRICAL SWITCHING APPARATUS
DISPOSITIF DE COMMUTATION ÉLECTRIQUE

(30) Priorität: 18.12.2020 DE 102020216305
(43) Veröffentlichungstag der Anmeldung: 27.07.2022
(73) Patentinhaber: LEONI Bordnetz-Systeme GmbH, 97318 Kitzingen (DE)
(72) Erfinder: MEYER, Marco, 97318 Kitzingen (DE); SUMMA, Karl-Heinz, 97320 Großlangheim (DE)
(74) Vertreter: FDST Patentanwälte

(56) Entgegenhaltungen:
- WO-A1-2009/081769
- WO-A1-2018/111001
- US-B1- 6 587 346
- US-B1- 6 833 997

## Beschreibung

Die Erfindung betrifft eine elektrische Schaltvorrichtung insbesondere ausgebildet für ein Kraftfahrzeug und aufweisend eine Leiterplatine mit einer Oberseite und mit einer Unterseite, wobei sich die Leiterplatine in einer Längsrichtung und in einer Querrichtung erstreckt, aufweisend zumindest einen elektronischen Leistungsschalter, welcher auf der Oberseite der Leiterplatine angebracht ist, sowie aufweisend eine erste Stromschiene, welche sich in Längsrichtung erstreckt und elektrisch leitend mit dem zumindest einen Leistungsschalter verbunden ist.

US 6 833 997 B1 offenbart eine Leiterplattenanordnung, in der stromführende Leiterplattenspuren zwischen MOSFETs oder dergleichen und Randanschlüssen durch Metallrahmenstrukturen ersetzt sind, die auch dazu dienen, eine Wärmeableitungsfunktion auszuführen. Jeder der Leiterrahmen umfasst einen ersten planaren Abschnitt, der durch ein wärmeleitendes Epoxid mit der oberen Oberfläche eines MOSFET verbunden ist, und einen zweiten erhöhten planaren Abschnitt, der sich parallel zu, aber oberhalb der Leiterplattenoberfläche in Kontakt mit einem am Rand angebrachten Anschlusskopf erstreckt. Die Leiterrahmen können mit Stützbeinen sowie zusätzlichen wärmeableitenden Rippen versehen sein.

WO 2018/111001 A1 offenbart eine Leistungsrelaisanordnung umfassend eine Stützplatte mit mindestens einem elektrischen Element, das auf einer Oberfläche davon montiert ist und ein Kunststoffmaterial mit Wärmeableitungs- und Isolationseigenschaften enthält; und mindestens eine Sammelschiene, die elektrisch mit dem elektrischen Element verbunden ist und teilweise in die Stützplatte eingebettet ist. Da aufgrund dieser Merkmale von der Sammelschiene und dem elektrischen Element erzeugte Wärme durch die Stützplatte nach außen abgeleitet wird, ist es möglich, eine Leistungsverschlechterung aufgrund von Wärme und Bruch elektronischer Komponenten zu verhindern.

WO 2009/081769 A1 offenbart einer Leiterplatte mit einem Metallkern und einem Anschlussblock aus einem isolierenden Blockkörper und einer Vielzahl von Anschlüssen für effiziente Durchwärm- und Wärmeabgabevorgänge.

US 6 587 346 B1 offenbart ein elektronisches System und ein Gehäuse mit einer Basis und einem Deckel. Eine Leiterplatte ist auf der Basis des Gehäuses installiert. Mindestens ein Lötpad ist auf der Leiterplatte zur Aufnahme eines elektronischen Bauelements angeordnet. Das Lötpad stellt sowohl eine elektrische Verbindung als auch eine mechanische Unterstützung für die elektronische Komponente bereit. Das elektronische System ist auch mit einer Vorrichtung versehen, die in der Lage ist, Leistung an die elektronische Komponente zu verteilen und gleichzeitig Wärme von der elektronischen Komponente abzuführen. Die Vorrichtung ist auch auf dem Lötpad montiert und benachbart zu der elektronischen Komponente positioniert.

Ein Bordnetz eines Kraftfahrzeugs weist typischerweise eine Anzahl Vorrichtungen auf zur Steuerung der Versorgung diverser Verbraucher mit elektrischer Energie und insbesondere zur Verteilung von elektrischer Leistung im Bordnetz des Kraftfahrzeugs. Für derartige Vorrichtungen sind diverse Bezeichnungen üblich, von denen einige auch für spezielle Ausführungsformen stehen. Bekannte Bezeichnungen sind Steuervorrichtung, Steuereinheit, Steuergerät, Leistungsverteiler, Stromverteiler, Schaltvorrichtung, Schalteinheit, Sicherungsbox, Sicherungseinheit etc.

Die Steuerung oder Verteilung erfolgt dabei üblicherweise mit Hilfe von Halbleiterschaltern, die bei einem Stromdurchfluss Abwärme oder Verlustwärme generieren. Diese Verlustwärme führt zu einer Eigenerwärmung der Halbleiterschalter, welche die Lebensdauer der Halbleiterschalter reduzieren und/oder zur Beschädigung der Halbleiterschalter oder umliegender Bauteile führen kann. Aus diesem Grund werden typischerweise Maßnahmen getroffen, um die generierte Verlustwärme abzuführen.

Dies gilt im Besonderen für Halbleiterschalter, die zum Schalten hoher Ströme ausgebildet sind. So ist in der EP 2 043 412 B1 beispielsweise eine elektrische Steuereinheit für ein Kraftfahrzeug beschrieben, bei der mehrere als sogenannte SMD-Bauteile ausgeführte Halbleiterschalter genutzt werden. Die Verlustwärme dieser Halbleiterschalter wird mit Hilfe eines Kühlkörpers mit Kühlrippen abgeführt, der thermisch leitend mit den SMD-Bauteilen verbunden ist.

Ausgehend hiervon liegt der Erfindung die Aufgabe zugrunde, eine vorteilhaft ausgebildete elektrische Schaltvorrichtung anzugeben.

Diese Aufgabe wird erfindungsgemäß gelöst durch eine elektrische Schaltvorrichtung mit den Merkmalen des Anspruchs 1. Bevorzugte Weiterbildungen sind in den rückbezogenen Ansprüchen enthalten.

Die erfindungsgemäße elektrische Schaltvorrichtung ist bevorzugt für ein Kraftfahrzeug ausgebildet und zur Realisierung eines Bordnetzes in einem Kraftfahrzeug vorgesehen. Dabei ist die elektrische Schaltvorrichtung, welche nachfolgend auch kurz als Schaltvorrichtung bezeichnet wird, üblicherweise zur Steuerung der Versorgung diverser Verbraucher mit elektrischer Energie und insbesondere zur Verteilung von elektrischer Leistung in einem Bordnetz eines Kraftfahrzeugs eingerichtet.

Die elektrische Schaltvorrichtung weist eine Leiterplatine oder Leiterplatte auf. Weiter weist die Schaltvorrichtung zumindest einen elektronischen Leistungsschalter auf, der auf einer Oberseite der Leiterplatine angebracht ist und mit dem somit also quasi zumindest ein Teil der Bestückung der Leiterplatine ausgebildet ist.

Der Leistungsschalter ist typischerweise ausgebildet als sogenannter SMD-Baustein (SMD: Surface-mounted device). Davon unabhängig weist der Leistungsschalter üblicherweise einen Halbleiterschalter auf, beispielsweise einen sogenannten MOSFET (Metall-Oxid-Halbleiter-Feldeffekttransistor), oder ist durch einen solchen Halbleiterschalter ausgebildet.

Derartige Leistungsschalter weisen typischerweise eine Elektronik auf, welche in einem Gehäuse aus Isoliermaterial aufgenommen ist, aus dem Kontaktfüße heraustreten, die zur Kontaktierung der Elektronik mit der Leiterplatine vorgesehen sind. Diese Kontaktfüße, auch als Kontaktstifte oder Kontaktpins bezeichnet, werden nachfolgend auch als Verbindungsarme bezeichnet. Beim Gehäuse handelt es sich beispielsweise um ein gegossenes Gehäuse.

Die Leiterplatine weist eine Ausdehnung in einer Längsrichtung und in einer Querrichtung auf, wobei die Längsrichtung und die Querrichtung typischerweise senkrecht zu zueinander orientiert sind. Weiter ist der Leistungsschalter derart auf der Leiterplatine angebracht, dass eine Vorderseite des Leistungsschalters der Oberseite der Leiterplatine zugewandt ist und eine Rückseite des Leistungsschalters von der Oberseite der Leiterplatine abgewandt ist.

Weiterhin ist eine erste Stromschiene Teil der elektrischen Schaltvorrichtung, welche sich in Längsrichtung erstreckt. Die erste Stromschiene ist elektrisch leitend mit dem zumindest einen Leistungsschalter verbunden. Die Verbindung ist dabei je nach Ausführungsvariante als direkte Verbindung ausgeführt, also als Kontaktierung beispielsweise durch eine Lötstelle, oder als indirekte Verbindung beispielsweise über eine Leiterbahn oder Leiterstruktur auf der Leiterplatine. Der Leistungsschalter weist typischerweise Kontaktfüße auf, über die er mit der Leiterplatine verbunden ist und über die er elektrisch kontaktiert ist.

Die erste Stromschiene ist an der Oberseite oder im Bereich der Oberseite der Leiterplatine angeordnet. Sie weist einen Mittenbereich auf, welcher einen überdeckenden Abschnitt bildet und der - in Richtung einer Flächennormalen der Oberseite der Leiterplatine betrachtet - oberhalb des zumindest einen elektronischen Leistungsschalters verläuft. Dieser Abschnitt überdeckt oder überdacht dann quasi den zumindest einen elektronischen Leistungsschalter. Bei der Verwendung von mehreren Leistungsschaltern überdeckt der Mittenbereich beispielsweise streifenförmig sämtliche Leistungsschalter. Hierdurch liegen schließlich der Mittenbereich und die Rückseite des zumindest einen Leistungsschalters einander gegenüber und/oder berühren einander. Der Leistungsschalter ist daher zwischen der Leiterplatine und der ersten Stromschiene angeordnet.

Für eine verbesserte Wärmeabfuhr ist die erste Stromschiene mit dem zumindest einen Leistungsschalter thermisch leitend verbunden und zwar insbesondere derart, dass zumindest ein Teil der Abwärme oder Verlustwärme des Leistungsschalters über die Rückseite des Leistungsschalters hin zur ersten Stromschiene abgeführt werden kann und im Betrieb auch abgeführt wird. Bei dieser thermisch leitenden Verbindung handelt es sich um eine zusätzliche Verbindung neben der elektrischen Verbindung zwischen der ersten Stromschiene und dem zumindest einen Leistungsschalter. Das Abführen oder Wegführen des Verlustwärme erfolgt zumindest vorwiegend durch Wärmeleitung.

Dadurch wird eine zusätzliche Wärmeableitung über die Rückseite des Leistungsschalters erreicht. Anders als bei der Anordnung im Stand der Technik, bei der die Wärmeableitung über die zur Platine orientierte Vorderseite und über eine separate Kühlstruktur erfolgt. Die hier beschriebene Wärmeabfuhr über die Rückseite erfolgt vorzugsweise ergänzend zu einer Wärmeabfuhr über die der Leiterplatine zugewandten Vorderseite des Leistungsschalters. Insgesamt wird hierdurch eine verbesserte Wärmeabfuhr erreicht, so dass die Temperaturbelastung des Leistungsschalters im Betrieb geringgehalten ist.

Bevorzugt ist die erste Stromschiene aus einem Metall gefertigt ist, wie beispielsweise Aluminium oder Kupfer, oder aus einer Metalllegierung. Die Stromschiene ist bevorzugt einteilig und einstückig ausgebildet, also quasi monolithisch. Sie ist zum Beispiel durch ein Stanzbiegeblech ausgebildet ist. Die erste Stromschiene typischerweise einen Mindestquerschnitt von wenigstens 10 mm² auf. Bevorzugt ist weiter ein Mindestquerschnitt von 20 mm² und insbesondere ein Mindestquerschnitt von wenigstens 30 mm². Davon unabhängig beträgt die Stromtragfähigkeit der ersten Stromschiene in den meisten Anwendungsfällen wenigstens 50 A, bevorzugt wenigstens 100 A und weiter bevorzugt wenigstens 150 A.

Der zumindest eine Leistungsschalter wiederum ist üblicherweise ausgelegt für eine Durchleitung oder ein Durchschalten von Strömen mit einer Stromstärke von wenigstens 5 A und vorzugsweise zumindest 10 A. Außerdem sind im Falle der meisten Ausführungsvarianten der Schaltvorrichtung mehrere Leistungsschalter, typischerweise mehr als 5 Leistungsschalter, und insbesondere mehrere gleichartige Leistungsschalter vorgesehen, welche dann zudem bevorzugt auf der Oberseite der Leiterplatine angebracht sind. Diese Leistungsschalter sind dabei typischerweise in einer Parallelschaltung miteinander verschaltet, sodass durch synchrones Ansteuern der Leistungsschalter in Summe üblicherweise Ströme größer gleich 50 A, bevorzugt größer gleich 100 A und insbesondere größer gleich 150 A durchschaltbar sind.

Für die thermisch leitende Verbindung zwischen der ersten Stromschiene und dem zumindest einen Leistungsschalter ist bevorzugt ein Wärmeleitelement vorgesehen, welches als ein gegenständlicher Körper ausgebildet ist. Das Wärmeleitelement dient als eine Art Wärmebrücke, über die im Leistungsschalter generierte Abwärme oder Verlustwärme vom Leistungsschalter hin zur ersten Stromschiene weitergeleitet wird. Das Wärmeleitelement liegt einerseits flächig am Leistungsschalter, also insbesondere flächig an dessen Isoliergehäuse, und andererseits flächig an der ersten Stromschiene an. Durch das Wärmeleitelement ist eine vorteilhafte thermische Anbindung gewährleistet. Es ist typischerweise durch einen Feststoff gebildet, der insbesondere einen Zwischenraum zumindest teilweise und vorzugsweise vollständig ausfüllt. Der Zwischenraum ist dabei zwischen der Leiterplatte und/oder dem Leistungsschalter und der ersten Stromschiene ausgebildet. Speziell wird unter Zwischenraum ein vertikaler Freiraum in Richtung einer Flächennormalen der Leiterplatte oder des Leistungsschalters verstanden. D.h. der Zwischenraum zwischen insbesondere dem Mittenbereich der ersten Stromschiene und der Rückseite des zumindest einen elektronischen Leistungsschalters wird von dem Feststoff zumindest teilweise und vorzugsweise vollständig ausfüllt. Alternativ zu einem Feststoff kann auch ein pastöser Stoff verwendet werden.

Üblicherweise sind mehrere, beispielsweise gleichartige elektronische Leistungsschalter in Längsrichtung nebeneinander auf der Oberseite der Leiterplatine angeordnet. Jeder dieser Leistungsschalter ist mit der ersten Stromschiene thermisch leitend verbunden, und zwar bevorzugt jeweils über ein Wärmeleitelement und insbesondere über ein gemeinsames Wärmeleitelement.

Für eine besonders gute Wärmeanbindung ist die erste Stromschiene in bevorzugter Ausgestaltung zumindest im Bereich des zumindest einen Leistungsschalters und insbesondere im Bereich aller Leistungsschalter in das Wärmeleitelement eingebettet.

Sofern vorliegend von Wärmeleitelement gesprochen wird, so wird hierunter insbesondere eine Element aus einem elektrisch isolierenden Werkstoff verstanden. Über das Wärmeleitelement wird daher keine elektrisch leitende Verbindung hergestellt.

Vorzugsweise ist das Wärmeleitelement durch eine ausgehärtete Vergussmasse ausgebildet, also zum Beispiel durch einen Kunststoff oder ein Epoxidharz.

Alternativ zur Vergussmasse ist das Wärmeleitelement beispielsweise durch eine Paste, durch einen Kleber oder auch durch eine Folie, insbesondere eine Klebefolie gebildet.

Bevorzugt erstreckt sich das Wärmeleitelement bis und insbesondere nur bis zur Oberseite der Leiterplatine. Speziell sind sämtliche Komponenten, die oberhalb der Oberseite der Leiterplatine angeordnet sind, im Wärmeleitelement eingebettet. Dies betrifft daher insbesondere die Leistungsschalter sowie die erste Stromschiene, zumindest deren Mittenbereich. Die Leiterplatine begrenzt daher insofern das speziell als Gussmasse ausgebildete Wärmeleitelement zu einer Seite hin. Die gegenüberliegende Unterseite der Leiterplatine und mit dieser insbesondere auch eine dort angeordnete zweite Stromschiene ist nicht im Wärmeleitelement eingebettet.

Das Wärmeleitelement weist zweckdienlicherweise eine thermische Leitfähigkeit auf, die größer ist als 0,15 W/mK. Bevorzugt ist weiter eine Ausführung, bei der die thermische Leitfähigkeit größer gleich 0,3 W/mK ist oder bei der die thermische Leitfähigkeit größer gleich 0,8 W/mK ist. Typischerweise liegt die thermische Leitfähigkeit in einem Bereich zwischen 0,2 W/mK bis 0,5 W/mK oder in einem Bereich von 1-10 W/mK.

Bevorzugt schließt sich seitlich an den Mittenbereich der ersten Stromschiene in Querrichtung gesehen an zumindest einer Seite ein Flankenbereich an mit zumindest einem Verbindungsarm, welcher insbesondere ausgebildet ist nach Art eines Kontaktstifts oder Kontaktpins. Über diesen erfolgt insbesondere die elektrische Kontaktierung des Leistungsschalters mit der Leiterplatine. Der Verbindungsarm ist in Querrichtung gesehen seitlich neben dem zumindest einen Leistungsschalter am Leistungsschalter vorbeigeführt. Hierdurch wird der Leistungsschalter für eine gute Wärmeableitung über die Stromschiene von zumindest zwei Seiten eingefasst. Der Abstand in Querrichtung zwischen dem zumindest einen Verbindungsarm und dem zumindest einen Leistungsschalter ist bevorzugt kleiner als die Ausdehnung des Leistungsschalters in Querrichtung, insbesondere kleiner als das 0,5-fache der Ausdehnung.

Bevorzugt sind Verbindungsarme beidseitig des Mittenbereichs angeordnet, so dass die erste Stromschiene - zumindest bei einer Projektion der ersten Stromschiene in Längsrichtung auf eine Bildebene betrachtet - eine U-förmige Struktur ausbildet. Innerhalb dieser U-förmigen Struktur ist der zumindest eine und sind vorzugsweise mehrere in Längsrichtung aufeinanderfolgende Leistungsschalter angeordnet. Bevorzugt sind auf jeder Seite jeweils mehrere Verbindungsarme beispielsweise in einer Reihe angeordnet. Diese Verbindungsarme bilden jeweils einen Flankenbereich aus, der beispielsweise in der Form eines Kamms ausgebildet.

Die Verbindungsarme und insbesondere die beiden Flankenbereiche sind in Längsrichtung vorzugsweise versetzt zueinander angeordnet. Insbesondere in diesem Fall weist dann die erste Stromschiene an zwei gegenüberliegenden Rändern jeweils eine Anzahl Verbindungsarme oder Kontaktpins auf. Die Leistungsschalter sind dann weiter bevorzugt in zwei Gruppen angeordnet, wobei die Leistungsschalter der einen Gruppe gegenüber den Leistungsschaltern der anderen Gruppe üblicherweise um 180° gedreht sind. Dies dient zum Beispiel zur Verteilung der Strombelastung auf die gesamte Breite der ersten Stromschiene. Je nach Länge der bevorzugt in Reihe platzierten Leistungsschalter dient diese 180°-Anordnung dem toleranzausgleich und der thermischen Ausdehnung zur Spannungsverteilung und der geometrischen Stabilisierung der Baugruppe vor einem Löten. Es ist z.B. auch eine gegenüberliegende Anordnung zweckdienlich je nach Bauraumanforderung bei gleicher Fläche. Die Anordnung hängt auch von Gleichteilkonzepten mit Bestückvarianten ab, kann also auch bei gleicher Stromschiene reduzierte Anzahl bestückter Leistungsschalter bedeuten. Hierbei kann dann das zeitliche Verhalten unter Belastung an die Anforderungen angepasst werden.

Bevorzugt füllt das Wärmeleitelement einen Zwischenraum zwischen dem zumindest einen Leistungsschalter, insbesondere zwischen den mehreren Leistungsschaltern und der ersten Stromschiene insbesondere vollständig aus, wobei der Zwischenraum bei dieser Ausführungsvariante auf einer Seite begrenzt ist durch den Mittenbereich der ersten Stromschiene und auf einer weiteren Seite durch zumindest einen der zuvor beschriebenen Verbindungsarme. Der Zwischenraum setzt sich hierbei also aus dem zuvor bereits beschriebenen vertikalen Freiraum und ergänzend einem lateralen Freiraum zusammen. Bevorzugt füllt das Wärmeleitelement daher den Zwischenraum aus, welcher - in Projektion in Längsrichtung betrachtet - durch die gegenüberliegenden Verbindungsarme und den Mittenbereich begrenzt ist.

Weiter weist die Schaltvorrichtung eine zweite Stromschiene auf, die an einer Unterseite oder im Bereich der Unterseite der Leiterplatine angeordnet ist. Bevorzugt liegt die zweite Stromschiene unmittelbar an der Unterseite der Leiterplatine an. Die zweite Stromschiene ist ebenfalls mit dem zumindest einen elektronischen Leistungsschalter elektrisch leitend verbunden. Die elektrische Verbindung ist hierbei analog zur ersten Stromschiene je nach Anwendungsfall als direkte oder als indirekte Verbindung ausgeführt. Über die eine der Stromschienen erfolgt eine elektrische Kontaktierung eines Leistungseingangs und über die andere Stromschiene erfolgt die Kontaktierung eines Leistungsausgangs des jeweiligen Leitungsschalters.

Die zweite Stromschiene ist wie die erste Stromschiene für hohe Ströme von z.B. wenigstens 50 A und weiter bevorzugt wenigstens 100 A ausgebildet Sie besteht insbesondere aus Metall und ist beispielsweise als ein Stanzbiegeblech ausgebildet. Insgesamt ist daher bei der elektrischen Schaltvorrichtung eine Art SandwichBauweise realisiert, bei der der zumindest eine auf der Leiterplatine angebrachte Leistungsschalter bzw. die mehreren typischerweise in einer Ebene angeordneten Leistungsschalter in einem Bereich zwischen der ersten Stromschiene und der zweiten Stromschiene positioniert ist /sind und bei der dann Abwärme oder Verlustwärme in zwei entgegengesetzte Richtungen, nämlich einmal hin zur ersten Stromschiene und einmal hin zur zweiten Stromschiene über Wärmeleitung abgeführt werden kann und im Betrieb auch abgeführt wird.

Die Schaltvorrichtung weist dabei insbesondere lediglich eine einzige Leiterplatine auf, an deren gegenüberliegenden Seiten und unter Zwischenlage der Leistungsschalter die beiden Stromschienen verlaufen.

Auch die zweite Stromschiene ist thermisch leitend mit dem zumindest einen Leistungsschalter verbunden. Die Wärme des Leistungsschalters wird daher über beiden Stromschienen abgeleitet. Die zweite Stromschiene ist hierzu vorzugsweise mit einer Vorderseite des Bauteils, welche zur Leiterplatine hin orientiert ist, thermisch leitend verbunden, und zwar insbesondere unabhängig von der elektrisch leitenden Verbindung. Die zweite Stromschiene berührt für die thermisch leitende Verbindung entweder direkt den Leistungsschalter, also insbesondere dessen Gehäuse. Alternativ ist ein Wärmeleitelement für die thermische Kopplung mit dem Leistungsschalter vorgesehen.

Zur Ausbildung der insbesondere direkten thermisch leitenden Verbindung zwischen der zweiten Stromschiene und dem zumindest ein Leistungsschalter weist die Leiterplatine im Bereich des zumindest einen Leistungsschalters bevorzugt einen Durchbruch auf. Die zweite Stromschiene weist ergänzend einen Zapfen auf, der beispielsweise durch Umbiegen erzeugt ist, und der in den Durchbruch eintaucht oder durch diesen hindurchgeführt ist. Der Zapfen liegt an dem Leistungsschalter insbesondere direkt an oder auch alternativ über ein zusätzliches Wärmeleitelement wie z.B. eine Wärmeleitpaste. Bei dem Wärmeleitelement handelt es sich wiederum vorzugsweise um ein Element aus einem elektrischen Isoliermaterial. Die thermisch leitende Verbindung ist also über diesen Zapfen mit der zur Leiterplatine orientieren Vorderseite des zumindest einen Leistungsschalters ausgebildet. Es handelt sich bevorzugt lediglich um eine thermisch leitende Verbindung, ohne dass eine elektrisch leitende Verbindung erfolgt. D.h. über den Zapfen erfolgt vorzugsweise lediglich eine thermisch leitende Verbindung mit einem Isoliergehäuse des jeweiligen Leistungsschalters.

Bevorzugt ist der Zapfen in den Durchbruch eingepresst und damit an der Leiterplatine mechanisch befestigt. Der Zapfen ist bevorzugt ausschließlich durch einen Presssitz gehalten. Alternativ oder ergänzend ist der Zapfen beispielsweise eingeklebt oder mit der Leiterplatine verlötet.

Bevorzugt weist die Leiterplatine im Bereich eines jeden Leistungsschalters jeweils einen solchen Durchbruch auf und die zweite Stromschiene für jeden Leistungsschalter einen entsprechenden Zapfen.

An der zweiten Stromschiene kann weiterhin ein insbesondere gerippter Kühlkörper angeordnet sein. Vorliegend wird auf einen Kühlkörper jedoch vorzugsweise verzichtet. Die Wärmeabfuhr erfolgt ausschließlich über die beiden Stromschienen.

Bevorzugt ist die zweite Stromschiene als Leistungseingang für einen Anschluss an eine Stromquelle oder für eine Verbindung mit einer Stromquelle ausgebildet. Im verbauten Zustand der elektrischen Schaltvorrichtung in einem Bordnetz eines Kraftfahrzeugs bildet daher die zweite Stromschiene einen solchen Leistungseingang aus. Die Stromquelle wird zum Beispiel durch einen Kraftfahrzeug-Akkumulator ausgebildet oder durch einen elektrischen Generator. Ergänzend ist hierbei typischerweise die erste Stromschiene als ein Leistungsausgang ausgebildet und bildet im verbauten Zustand der Schaltvorrichtung einen entsprechenden Leistungsausgang aus. An einen entsprechenden Leistungsausgang schließen sich im verbauten Zustand ein oder mehrere Laststrompfade an mit jeweils zumindest einem elektrischen Verbraucher.

Bei der elektrischen Schaltvorrichtung handelt es sich insbesondere um eine sogenannte Vorsicherungsdose für ein Kraftfahrzeug. Hierbei bilden dann die Leiterplatine mitsamt ihrer Bestückung, also insbesondere auch den drauf angebrachten Leistungsschaltern, die beiden Stromschienen, also die erste Stromschiene und die zweite Stromschiene, sowie das Wärmeleitelement eine elektronische Sicherungseinheit aus, welche insbesondere nach Art einer sogenannten eFuse ausgestaltet ist, also als elektronische Sicherung. Die elektronische Sicherungseinheit ist somit dann vorzugsweise eingerichtet oder ausgestaltet als eine Art Schutzschalter.

Die elektrische Schaltvorrichtung weist vorzugsweise zusätzlich zu der elektronischen Sicherungseinheit weitere Lastanschlüsse auf, die jeweils über ein Sicherungselement, beispielsweise eine Schmelzsicherung, abgesichert sind. An diese Lastanschlüsse sind im montierten Zustand weitere Lastpfade mit Verbrauchern angeschlossen. Über die elektronisches Sicherungseinheit wird zumindest ein oder mehrere, insbesondere zwei Hochstrompfade versorgt. Diese dienen zur Versorgung von Hochleistungskomponenten wie z.B. EKMV (elektrische Kühlmittelversorgung/elektrische Wasserpumpe), eKat (Katalysatorheizung) oder ähnliche Komponenten. Diese Hochstrompfade sind für höhere Ströme im Vergleich zu den weiteren Lastpfaden ausgelegt. Über die elektronische Sicherungseinheit werden z.B. in Summe über 100A an den Hochstrompfaden bereitgestellt, wobei ein jeder Hochstrompfad zumindest 30A aufweist. Ein jeder der weiteren Lastpfade ist demgegenüber mit einem geringeren Stromwert z.B. mit 10A oder mit 20A abgesichert.

Ausführungsbeispiele der Erfindung werden nachfolgend anhand einer schematischen Zeichnung näher erläutert. Darin zeigen:
- FIG 1: in einer perspektivischen Ansicht eine Vorsicherungsdose,
- FIG 2: in einer perspektivischen Ansicht eine Verteilerschiene und eine daran angeschlossene elektronische Sicherungseinheit,
- FIG 3: in einer perspektivischen Ansicht die elektronische Sicherungseinheit aufweisend eine Leiterplatine mit mehreren Leistungsschaltern, zwei Stromschienen und mit einem Wärmeleitelement,
- FIG 4: in einer perspektivischen Ansicht die elektronische Sicherungseinheit ähnlich FIG 3 ohne das Wärmeleitelement,
- FIG 5: in einer perspektivischen Ansicht die Leiterplatine mit den Leistungsschaltern,
- FIG 6: in einer Seitenansicht die elektronische Sicherungseinheit ohne das Wärmeleitelement sowie
- FIG 7: in einem ausschnittsweisen Querschnitt die elektronische Sicherungseinheit.

Einander entsprechende Teile sind in allen Figuren jeweils mit den gleichen Bezugszeichen versehen.

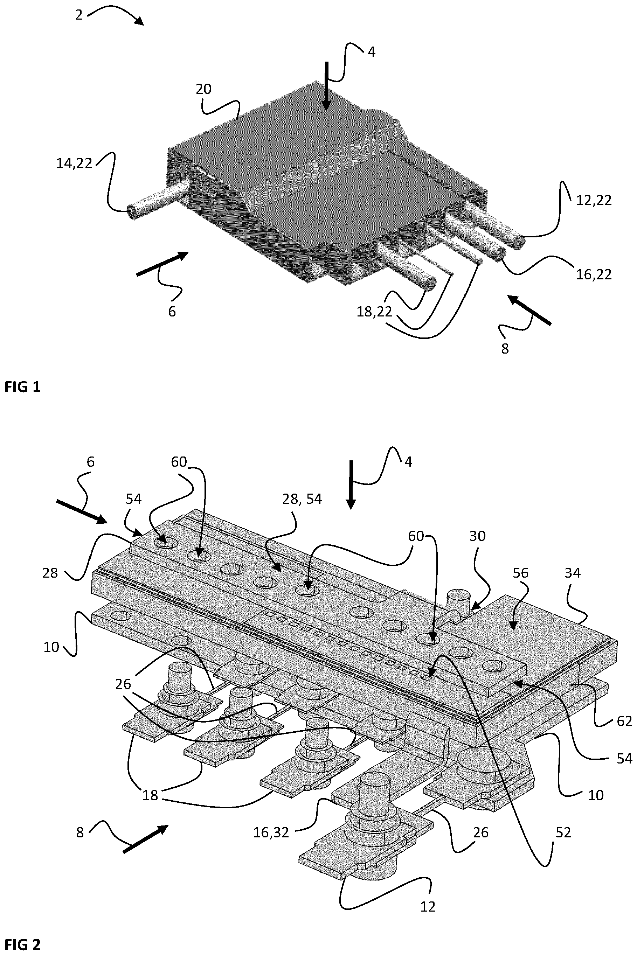

Eine nachfolgend exemplarisch beschriebene in FIG 1 dargestellte elektrische Schaltvorrichtung ist als eine sogenannte Vorsicherungsdose 2 für ein Kraftfahrzeug ausgebildet und dementsprechend für den Einsatz in einem Bordnetz eines Kraftfahrzeugs vorgesehen.

Für eine einfachere Beschreibung der Vorsicherungsdose 2 sind in den Darstellungen der FIG 1 bis FIG 7 jeweils drei orthogonale Raumrichtungen dargestellt, nämlich eine Vertikalrichtung 4, eine Längsrichtung 6 sowie eine Querrichtung 8.

Die in FIG 1 dargestellte Vorsicherungsdose 2 weist eine Verteilerschiene 10 (vgl. Fig. 2) auf, über die ein Eingangsanschluss 12 und mehrere Ausgangsanschlüsse 14, 16,18 für die Vorsicherungsdose 2 realisiert sind. Die einzelnen Anschlüsse 12 bis 18 unterscheiden sich dabei im Ausführungsbeispiel im Hinblick auf die Strombelastbarkeit, für die die einzelnen Anschlüsse 12 bis 18 ausgelegt sind. Der Eingangsanschluss 12 ist hierbei für die höchste Strombelastbarkeit und beispielsweise für mehrere 100 A ausgelegt. Weiter sind all diese Anschlüsse 12 bis 18, also der Eingangsanschluss 12 und die Ausgangsanschlüssen 14 bis 18 innerhalb eines Gehäuses 20 der Vorsicherungsdose 2 angeordnet. Im verbauten Zustand der Vorsicherungsdose 2 sind an die Anschlüsse 12 bis 18 angeschlossene Kabel 22 aus dem Gehäuse 20 herausgeführt, so wie dies in FIG 1 angedeutet ist.

In FIG 2 ist die Vorsicherungsdose 2 ohne das Gehäuse 20 sowie ohne angeschlossene Kabel 22 dargestellt. Aus dieser Darstellung ist, zumindest in Zusammenschau mit den übrigen Darstellungen, zu entnehmen, dass bei der Vorsicherungsdose 2 alle Anschlüsse 12 bis 18 als abgesicherter Anschlüsse 12 bis 18 ausgebildet sind, wobei ein erster Ausgangsanschluss 14 sowie ein zweiter Ausgangsanschluss 16 über eine elektronische Sicherungseinheit 24 abgesichert ist und wobei die weiteren Ausgangsanschlüsse 18 sowie der Eingangsanschluss 12 jeweils durch integrierte Schmelzsicherungen 26 abgesichert sind.

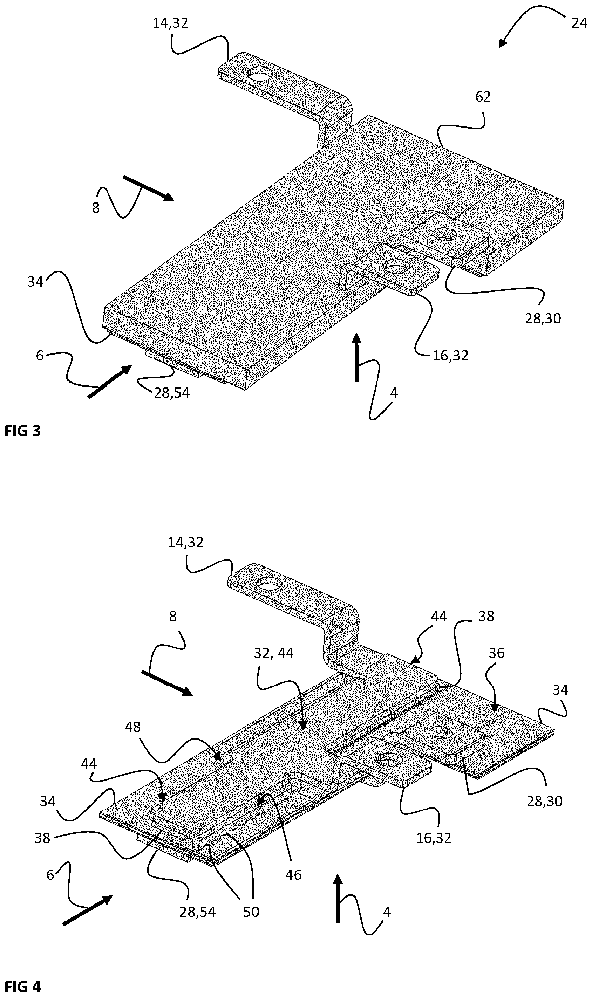

Der Aufbau der elektronischen Sicherungseinheit 24 oder kurz Sicherungseinheit 24 wird im Zusammenhang mit den FIG 3 bis FIG 7 näher erläutert. Sie weist eine erste Stromschien 32 sowie eine zweite Stromschiene 28 auf. Die zweite Stromschiene weist einen Leistungseingang mit einem Eingangsanschluss 30 auf sowie im Ausführungsbeispiel zwei Ausgangsanschlüsse, nämlich der erste Ausgangsanschluss 14 und der zweite Ausgangsanschluss 16. Der Eingangsanschluss 30 sowie die beiden Ausgangsanschlüsse 14,16 sind jeweils als umgebogene L-förmige Laschen ausgebildet, die ein Schraubloch aufweisen. Der Eingangsanschluss 30 der elektronischen Sicherungseinheit 24 ist im Ausführungsbeispiel mit einem Nebenarm der Verteilerschiene 10 und daher mit dem Eingangsanschluss 12 elektrisch leitfähig verbunden, beispielsweise verschraubt.

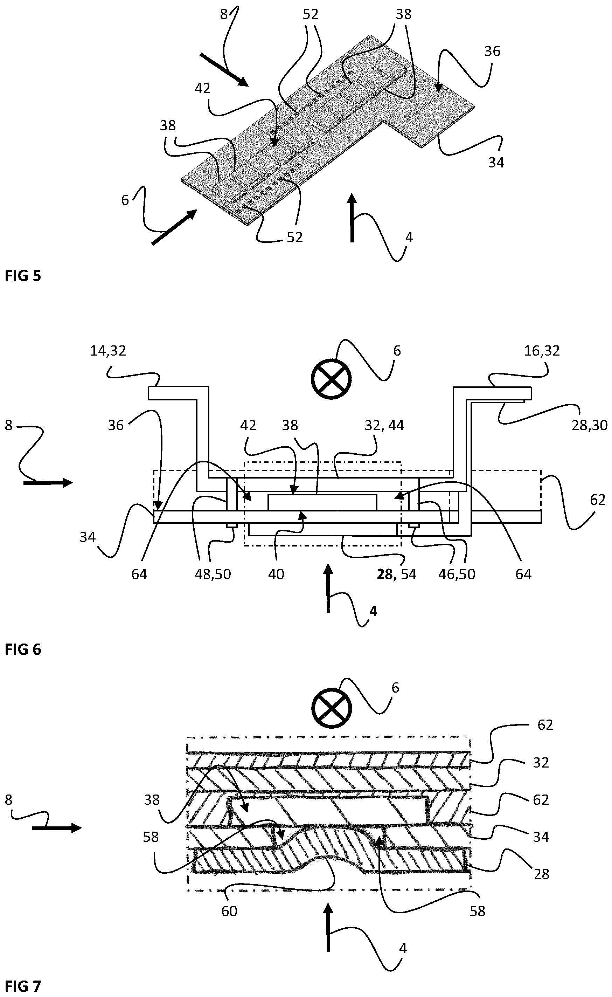

Die Sicherungseinheit 24 weist eine im Detail in FIG 5 dargestellte Leiterplatine 34 auf, die in Längsrichtung 6 einerseits und in Querrichtung 8 andererseits ausgedehnt ist. Auf einer Oberseite 36 der Leiterplatine 34 sind mehrere elektronische Leistungsschalter 38 angebracht, die somit zumindest einen Teil der Bestückung der Leiterplatine 34 ausbilden. Die Leistungsschalter 38 weisen eine Vorderseite 40 auf, die der Leiterplatine 34 zugewandt ist, sowie eine gegenüberliegende Rückseite 42, die von der Leiterplatine 34 abgewandt ist. Zudem sind die Leistungsschalter 38 in einer Reihe angeordnet, welche in Längsrichtung 6 verläuft.

Die Leistungsschalter 38 sind üblicherweise ausgebildet als sogenannte SMD-Bausteine (SMD: Surface-mounted device). Davon unabhängig weist jeder Leistungsschalter 38 typischerweise einen Halbleiterschalter, beispielsweise einen sogenannten MOSFET (Metall-Oxid-Halbleiter-Feldeffekttransistor), auf oder ist durch einen solchen Halbleiterschalter ausgebildet.

Die erste Stromschiene 32 ist oberhalb der Leiterplatine 34 angeordnet ist und somit der Oberseite 36 der Leiterplatine 34 zugewandt ist, wie insbesondere aus den FIG. 4 und 6 hervorgeht. Die erste Stromschiene weist einen sich in Längsrichtung 6 erstreckenden Mittenbereich 44 auf, der die Leistungsschalter 38 überdeckt oder überdacht. Wie aus FIG 6 hervorgeht ist dabei zwischen den Rückseiten 42 der Leistungsschalter 38 und dem Mittenbereich 44 ein Abstand gegeben. Der Mittenbereich 44 berührt somit die Rückseiten 42 der Leistungsschalter 38 im Ausführungsbeispiel nicht. Es ist daher ein vertikaler Freiraum oder Zwischenraum zwischen einer Oberseite des Leistungsschalters 38 und der ersten Stromschiene 32 ausgebildet.

Weiter weist die erste Stromschiene 32 im Ausführungsbeispiel zwei Flankenbereiche 46,48 auf, nämlich einen ersten Flankenbereich 46 und einen zweiten Flankenbereich 48, die sich in Querrichtung 8 gesehen beidseitig an den Mittenbereich 44 anschließen. Jeder der beiden Flankenbereiche 46,48 ist dabei als kammartige Struktur ausgebildet mit mehreren stiftartigen Verbindungsarmen 50, die sich entlang der Vertikalrichtung 4 hin zur Leiterplatine 34 erstrecken. Die Vertikalrichtung 4 bildet eine Normale zu der Leiterplatine 34. Die beiden Flankenbereiche 46,48 bilden zusammen mit dem Mittenbereich 44 eine U-förmige Struktur aus, zumindest bei einer Projektion der ersten Stromschiene in Längsrichtung 6 auf eine Bildebene (vgl. hierzu FIG 6).

Ergänzend weist die Leiterplatine 34 für jeden Verbindungsarm 50 eine Aufnahme 52 auf. Die Aufnahmen sind im Ausführungsbeispiel durch Durchbrüche in der Leiterplatine 34 ausgebildet, in die die Verbindungsarme 50 eingesteckt sind. Dabei werden die die Aufnahmen 52 ausbildenden Durchbrüche von den Verbindungsarmen 52 durchsetzt (FIG 6). Jeder Verbindungsarm 50 ist in der entsprechenden Aufnahme 52 beispielsweise eingepresst und / oder verlötet, sodass die erste Stromschiene über die Verbindungsarme 50 an der Leiterplatine 34 fixiert ist. Außerdem sind die Verbindungsarme 50 im Ausführungsbeispiel elektrisch leitend beispielsweise über hier nicht dargestellte Leiterbahnen der Leiterplatine 34 mit den Leistungsschaltern 38 verbunden.

Weiterhin weist die Sicherungseinheit 24 die zweite Stromschiene auf. Diese ist an einer Unterseite 56 der Leiterplatine 34 und damit an einer zur ersten Stromschiene 32 gegenüberliegenden Seite angeordnet. Wie speziell aus Fig. 4 oder FIG. 6 und FIG 7 hervorgeht, sind die Leistungsschalter 38 und die Leiterplatine 34 sandwichartig zwischen den beiden Stromschienen 28,32 angeordnet.

Auch die die zweite Stromschiene weist einen sich in Längsrichtung 6 erstreckenden mit Mittenbereich 54 auf, welcher im Ausführungsbeispiel an der Unterseite 56 der Leiterplatine 34 anliegt.

Auch die zweite Stromschiene ist in einer nicht näher dargestellten Weise elektrisch leitfähig mit den Leistungsschaltern 38 verbunden, wodurch sich schließlich ein über den Eingangsanschluss 30 und damit über die zweite Stromschiene zugeführter Strom über die Leistungsschalter 38 zur ersten Stromschiene 32 und zu den beiden Ausgangsanschlüssen 14,16 durchschalten lässt. Dabei ist jeder Leistungsschalter 38 üblicherweise ausgelegt für eine Durchleitung oder ein Durchschalten von Strömen mit einer Stromstärke von wenigstens 5 A und vorzugsweise zumindest 10 A. Außerdem sind im Ausführungsbeispiel die Leistungsschalter 38 in einer Parallelschaltung miteinander verschaltet, sodass durch synchrones Ansteuern der Leistungsschalter 38 in Summe Ströme größer gleich 50 A und insbesondere größer gleich 100 A durchschaltbar sind.

Zur Ausbildung einer thermisch leitenden Verbindung zwischen der ersten Stromschiene 32 und den Leistungsschaltern 38 ist im Ausführungsbeispiel eine thermisch leitende Verbindung mit Hilfe eines zusätzlichen Wärmeleitelements 62 ausgebildet. Das Wärmeleitelement 62 dient hierbei als eine Art Wärmebrücke, über die in den Leistungsschaltern 38 generierte Abwärme oder Verlustwärme hin zur ersten Stromschiene 32 weitergeleitet wird.

Das Wärmeleitelement 62 ist bevorzugt durch eine ausgehärtete Vergussmasse ausgebildet, also zum Beispiel durch einen Kunststoff oder ein Epoxidharz. Bevorzugt ist die erste Stromschiene 32 zumindest im Bereich der Leistungsschalter 38 in das Wärmeleitelement 62 eingebettet ist. Das durch die Vergussmasse ausgebildete Wärmeleitelement 62 überdeckt vorzugsweise die gesamte Leiterplatine 34. Beim Herstellen wird daher auf die in Fig. 4 dargestellte Einheit die Vergussmasse aufgebracht. Die erste Stromschiene 32 ist insbesondere vollständig in der Vergussmasse eingebettet, bis auf die abgewinkelten Anschlüsse 14,16,30.

Gleichzeitig begrenzt die Leiterplatine 34 das Wärmeleitelement 62, d.h. das Wärmeleitelement 62 erstreckt sich lediglich bis zu einer Seite der Leiterplatine 34, ohne dass diese in der Vergussmasse eingebettet ist. Insbesondere liegt die auf der gegenüberliegenden Seite der Leiterplatine 34 angeordnete zweite Stromschiene 28 frei uns ist nicht von der Vergussmasse umgeben.

Unabhängig von der genauen Ausgestaltung des Wärmeleitelements weist dieses zweckdienlicherweise eine thermische Leitfähigkeit auf, die größer ist als 0,15 W/mK. Bevorzugt ist weiter eine Ausführung, bei der die thermische Leitfähigkeit größer gleich 0,3 W/mK ist oder bei der die thermische Leitfähigkeit größer gleich 0,8 W/mK ist. Typischerweise liegt die thermische Leitfähigkeit in einem Bereich von 1-10 W/mK.

Im Ausführungsbeispiel füllt das Wärmeleitelement 62 unter anderem einen Zwischenraum 64 auf, der auf einer Seite begrenzt ist durch den Mittenbereich 44, auf einer weiteren Seite durch den ersten Flankenbereich 46, auf einer weiteren Seite durch den zweiten Flankenbereich 48 und auf einer weiteren Seite durch die Leiterplatine 34 mitsamt ihrer Bestückung, zu der insbesondere auch die auf der Leiterplatine 34 angebrachten Leistungsschalter 38 zählen. Der Umriss des Wärmeleitelements 62 ist in FIG 6 durch gestrichelte Linien wiedergegeben.

Zur thermisch leitfähigen Verbindung der zweiten Stromschiene 28 und den Leistungsschaltern 38 weist die Leiterplatine 34 im Ausführungsbeispiel im Bereich eines jeden Leistungsschalters 38 einen Durchbruch 58 auf, der vom zugehörigen Leistungsschalter 38 auf der Oberseite 36 der Leiterplatine 34 überdeckt wird. Ergänzend weist die zweite Stromschiene 28 für jeden Leistungsschalter 38 einen Zapfen 60 auf, der beispielsweise durch Umbiegen erzeugt ist, und jeder Zapfen 60 durchsetzt den zugehörigen Durchbruch 58 in der Leiterplatine zumindest teilweise. Die thermisch leitende Verbindung ist zwischen den Vorderseiten 40 der Leistungsschalter 38 und den Zapfen 60 ausgebildet, wobei hierzu jeder Zapfen 60 an der Vorderseite 40 des zugehörigen Leistungsschalters 38 anliegt. Dies ist aus FIG 7 zu entnehmen. FIG 7 zeigt eine ausschnittsweise Schnittdarstellung der Sicherungseinheit auf der Höhe eines Leistungsschalters. Zudem ist es vorteilhaft, wenn die zweite Stromschiene beispielsweise durch Erpressung der Zapfen 60 in die Durchbrüche 58 auch an der Leiterplatine 34 mechanisch befestigt ist, wobei die Erpressung beispielsweise mittels Durchsetzfügen realisiert ist.

Über den Zapfen 60 erfolgt insbesondere lediglich eine thermische Ankopplung, ohne dass eine elektrische Kontaktierung erfolgt. Für die elektrische Kontaktierung der Leistungsschalter 38 mit der zweiten Stromschiene 28 sind hier nicht näher dargestellte elektrische Verbindungen vorgesehen, z.B. Durchkontaktierungen in der Leiterplatine 34, mit denen dann entsprechende Kontaktfüße der Leistungsschalter 38 verbunden sind.

Durch den hier beschriebenen Aufbau wird eine besonders effiziente Wärmeabfuhr im Betrieb erreicht. Durch die erste Stromschiene 32 und deren thermische Anbindung über die Vergussmasse (Wärmeleitelement 62) an die Rückseite des Leistungsschalters 38 ist eine Wärmeabfuhr insbesondere in Ergänzung zu einer Wärmeabfuhr über die Vorderseite und die zweite Stromschiene 28 erreicht.

Untersuchungen haben gezeigt, dass sich hierdurch im Betrieb geringere Betriebstemperaturen einstellen.

Ist die Vorsicherungsdose 2 in einem Kraftfahrzeug verbaut und somit Teil des Bordnetzes des Kraftfahrzeugs, so ist der Eingangsanschluss 12 beispielsweise mit einem riemengetriebenen Startergenerator (RSG) verbunden, der im Betrieb typischerweise bis zu 190 A in die Vorsicherungsdose 2 einspeist. Der Ausgangsanschluss 14 ist dann zum Beispiel mit einer elektrischen Kühlmittelversorgung (EKMV) verbunden, die im Betrieb typischerweise einen Strombedarf bis zu 120 A hat. Der Ausgangsanschluss 16 ist beispielsweise mit einer Katalysatorheizung (e-Kat) verbunden, die im Betrieb typischerweise einen Strombedarf bis zu 40 A hat. An die Ausgangsanschlüsse 18 sind üblicherweise Komponenten angeschlossen, wie elektrischer Zusatzheizer (PTC), eine Batterie/ein Akkumulator oder ähnliches.

### Bezugszeichenliste

- 2: elektrische Schaltvorrichtung
- 4: Vertikalrichtung
- 6: Längsrichtung
- 8: Querrichtung
- 10: Verteilerschiene
- 12: Eingangsanschluss
- 14: erster Ausgangsanschluss
- 16: zweiter Ausgangsanschluss
- 18: weiterer Ausgangsanschluss
- 20: Gehäuse
- 22: Kabel
- 24: elektronische Sicherungseinheit
- 26: Schmelzsicherung
- 28: zweite Stromschiene
- 30: Eingangsanschluss
- 32: erste Stromschiene
- 34: Leiterplatine
- 36: Oberseite der Leiterplatine
- 38: elektronischer Leistungsschalter
- 40: Vorderseite des elektronischen Leistungsschalters
- 42: Rückseite deselektronischen Leistungsschalters
- 44: Mittenbereich der ersten Stromschiene
- 46: erster Flankenbereich
- 48: zweiter Flankenbereich
- 50: Verbindungsarm
- 52: Aufnahme
- 54: Mittenbereich der zweiten Stromschiene
- 56: Unterseite der Leiterplatine
- 58: Durchbruch
- 60: Zapfen
- 62: Wärmeleitelement
- 64: Zwischenraum

## Patentansprüche

1. Elektrische Schaltvorrichtung (2) insbesondere ausgebildet für ein Kraftfahrzeug und aufweisend
- eine Leiterplatine (34) mit einer Oberseite (36) und mit einer Unterseite (56), wobei sich die Leiterplatine (34) in einer Längsrichtung (6) und in einer Querrichtung (8) erstreckt,
- zumindest einen elektronischen Leistungsschalter (38), welcher auf der Oberseite (36) der Leiterplatine (34) angebracht ist, sowie
- eine erste Stromschiene (32), welche sich in Längsrichtung (6) erstreckt und elektrisch leitend mit dem zumindest einen Leistungsschalter (38) verbunden ist,
wobei
- die erste Stromschiene (32) an der Oberseite (36) der Leiterplatine (34) angeordnet ist und einen Mittenbereich (44) aufweist, der oberhalb des zumindest einen elektronischen Leistungsschalters (38) verläuft, und
- die erste Stromschiene (32) mit dem zumindest einen Leistungsschalter (38) thermisch leitend verbunden ist,
**dadurch gekennzeichnet,**
**dass**
- an der Unterseite (56) der Leiterplatine (34) eine zweite Stromschiene (28) angeordnet ist, welche ebenfalls mit dem zumindest einen elektronischen Leistungsschalter (38) elektrisch leitend verbunden ist, und
- die zweite Stromschiene (28) ebenfalls mit dem zumindest einen Leistungsschalter (38) thermisch leitend verbunden ist.

2. Elektrische Schaltvorrichtung (2) nach Anspruch 1,
**dadurch gekennzeichnet,**
**dass** die erste Stromschiene (32) über ein Wärmeleitelement (62) mit dem zumindest einen Leistungsschalter (38) thermisch leitend verbunden ist.

3. Elektrische Schaltvorrichtung (2) nach Anspruch 2,
**dadurch gekennzeichnet,**
**dass** mehrere elektronische Leistungsschalter (38) in Längsrichtung (6) nebeneinander auf der Oberseite (36) der Leiterplatine (34) angeordnet sind und dass die erste Stromschiene (32) mit jedem elektronischen Leistungsschalter (38) thermisch leitend verbunden ist, insbesondere über das Wärmeleitelement (62).

4. Elektrische Schaltvorrichtung (2) nach einem der Ansprüche 2 oder 3,
**dadurch gekennzeichnet,**
**dass** die erste Stromschiene (32) im Bereich des zumindest einen elektronischen Leistungsschalters (38) in das Wärmeleitelement (62) eingebettet ist.

5. Elektrische Schaltvorrichtung (2) nach einem der Ansprüche 2 bis 4,
**dadurch gekennzeichnet,**
**dass** das Wärmeleitelement (62) durch eine ausgehärtete Vergussmasse ausgebildet ist.

6. Elektrische Schaltvorrichtung (2) nach einem der Ansprüche 2 bis 5,
**dadurch gekennzeichnet,**
**dass** das Wärmeleitelement (62) sich lediglich bis zur Oberseite der Leiterplatine (34) erstreckt, so dass diese nicht im Wärmeleitelement (62) eingebettet ist.

7. Elektrische Schaltvorrichtung (2) nach einem der Ansprüche 2 bis 6,
**dadurch gekennzeichnet,**
**dass** das Wärmeleitelement (62) eine thermische Leitfähigkeit aufweist, die größer ist als 0,15 W/mK und insbesondere größer als 0,8 W/mK.

8. Elektrische Schaltvorrichtung (2) nach einem der vorhergehenden Ansprüche,
**dadurch gekennzeichnet,**
**dass** sich seitlich an den Mittenbereich (44) zumindest ein Verbindungsarm (50) anschließt, über den die erste Stromschiene (32) mit der Leiterplatine (34) verbunden ist, wobei der zumindest eine Verbindungsarm (50) in Querrichtung (8) gesehen seitlich neben dem elektronischen Leistungsschalter (38) am elektronischen Leistungsschalter (38) vorbeigeführt ist.

9. Elektrische Schaltvorrichtung (2) nach Anspruch 8,
**dadurch gekennzeichnet,**
**dass** sich in Querrichtung (8) gesehen an den Mittenbereich (44) beidseitig jeweils zumindest ein Verbindungsarm (50) anschließt, so dass der Mittenbereich (44) und die Verbindungsarme (50) - bei einer Projektion der ersten Stromschiene (32) in Längsrichtung (6) betrachtet - eine U-förmige Struktur bilden.

10. Elektrische Schaltvorrichtung (2) nach einem der Ansprüche 8 oder 9 und nach einem der Ansprüche 2 bis 7,
**dadurch gekennzeichnet,**
**dass** das Wärmeleitelement (62) einen Zwischenraum (64) vollständig ausfüllt, der auf einer Seite begrenzt ist durch den Mittenbereich (44) und bevorzugt weiterhin auf einer weiteren Seite durch den zumindest einen Verbindungsarm (50).

11. Elektrische Schaltvorrichtung (2) nach einem der Ansprüche 1 bis 10,
**dadurch gekennzeichnet,**
**dass** die zweite Stromschiene (28) mit einem Leistungseingang und die erste Stromschiene (32) mit einem Leistungsausgang des zumindest einen Leistungsschalters (38) verbunden ist.

12. Elektrische Schaltvorrichtung (2) nach einem der Ansprüche 1 bis 11,
**dadurch gekennzeichnet,**
**dass** die Leiterplatine (34) im Bereich des zumindest einen Leistungsschalters (38) einen Durchbruch (58) und die zweite Stromschiene (28) einen Zapfen (60) aufweist und dass der Zapfen (60) den Durchbruch (58) zumindest teilweise durchsetzt, so dass die zweite Stromschiene (28) insbesondere durch Verpressung an der Leiterplatine (34) befestigt ist.

13. Elektrische Schaltvorrichtung (2) nach einem der Ansprüche 1 bis 12,
**dadurch gekennzeichnet,**
**dass** die zweite Stromschiene (28) als Leistungseingang für einen Anschluss an eine Stromquelle, insbesondere einen Kraftfahrzeug-Akkumulator, ausgebildet ist und dass die erste Stromschiene (32) als Leistungsausgang für einen Anschluss an zumindest einen Verbraucher ausgebildet ist.

14. Elektrische Schaltvorrichtung (2) nach einem der Ansprüche 1 bis13,
**dadurch gekennzeichnet,**
**dass** diese als eine Vorsicherungsdose (2) für ein Kraftfahrzeug ausgebildet ist, bei der die Leiterplatine (34) zusammen mit den darauf angebrachten Leistungsschaltern (38), mit den beiden Stromschienen (28,32) eine elektronische Sicherungseinheit (24) ausbilden und bei der zusätzlich mehrere jeweils über ein Sicherungselement (26) abgesicherte Laststrompfade (18) angeordnet sind, die jeweils zum Anschluss einer elektrischen Leitung (22) ausgebildet sind.

## Claims

1. Electrical switching device (2), in particular configured for a motor vehicle and comprising
- a printed circuit board (34) with a top side (36) and a bottom side (56), wherein the printed circuit board (34) extends in a longitudinal direction (6) and in a transverse direction (8),
- at least one electronic power switch (38) which is fitted on the top side (36) of the printed circuit board (34), as well as
- a first busbar (32) which extends in the longitudinal direction (6) and is electrically-conductively connected to the at least one power switch (38),
wherein
- the first busbar (32) is arranged on the top side (36) of the printed circuit board (34) and has a central region (44) which runs above the at least one electronic power switch (38), and
- the first busbar (32) is thermally-conductively connected to the at least one power switch (38).
**characterized in that**
- a second busbar (28) is arranged on the bottom side (56) of the printed circuit board (34), which is also electrically-conductively connected to the at least one electronic power switch (38), and
- the second busbar (28) is also thermally-conductively connected to the at least one power switch (38).

2. Electrical switching device (2) according to claim 1,
**characterized in that** the first busbar (32) is thermally-conductively connected to the at least one power switch (38) via a heat-conducting element (62).

3. Electrical switching device (2) according to claim 2,
**characterized in that** a plurality of electronic power switches (38) are arranged in the longitudinal direction (6) next to one another on the top side (36) of the printed circuit board (34) and that the first busbar (32) is thermally-conductively connected to each electronic power switch (38), in particular via the heat-conducting element (62).

4. Electrical switching device (2) according to any one of claims 2 or 3,
**characterized in that** the first busbar (32) is embedded in the heat-conducting element (62) in the region of the at least one electronic power switch (38).

5. Electrical switching device (2) according to any one of claims 2 to 4,
**characterized in that** the heat-conducting element (62) is formed by a hardened casting compound.

6. Electrical switching device (2) according to any one of claims 2 to 5,
**characterized in that** the heat-conducting element (62) extends only to the top of the printed circuit board (34), such that the latter is not embedded in the heat-conducting element (62).

7. Electrical switching device (2) according to any one of claims 2 to 6,
**characterized in that** the heat-conducting element (62) has a thermal conductivity which is greater than 0.15 W/mK, and in particular greater than 0.8 W/mK.

8. Electrical switching device (2) according to any one of the preceding claims,
**characterized in that** at least one connecting arm (50) laterally adjoins the middle region (44), via which the first busbar (32) is connected to the printed circuit board (34), wherein the at least one connecting arm (50) is laterally guided past the electronic power switch (38) next to the electronic power switch (38), as viewed in the transverse direction (8).

9. Electrical switching device (2) according to claim 8,
**characterized in that**, as viewed in the transverse direction (8), at least one connecting arm (50) adjoins the central region (44) on both sides, such that the central region (44) and the connecting arms (50) - as viewed in a projection of the first busbar (32) in the longitudinal direction (6) - form a U-shaped structure.

10. Electrical switching device (2) according to any one of claims 8 or 9 and according to any one of claims 2 to 7,
**characterized in that** the heat-conducting element (62) completely fills an intermediate space (64), which is delimited on one side by the central region (44) and preferably further on a further side by the at least one connecting arm (50).

11. Electrical switching device (2) according to any one of claims 1 to 10,
**characterized in that** the second busbar (28) is connected to a power input and the first busbar (32) is connected to a power output of the at least one power switch (38).

12. Electrical switching device (2) according to any one of claims 1 to 11,
**characterized in that** the printed circuit board (34) has an opening (58) in the region of the at least one power switch (38) and the second busbar (28) has a pin (60), and that the pin (60) at least partially penetrates the opening (58) such that the second busbar (28) is attached to the printed circuit board (34) in particular by pressing.

13. Electrical switching device (2) according to any one of claims 1 to 12,
**characterized in that** the second busbar (28) is configured as a power input for connection to a power source, in particular a motor vehicle battery, and that the first busbar (32) is configured as a power output for connection to at least one consumer.

14. Electrical switching device (2) according to any one of claims 1 to 13,
**characterized in that** it is configured as a backup fuse box (2) for a motor vehicle, in which the printed circuit board (34) together with the power switches (38) fitted thereon, form an electronic fuse unit (24) with the two busbars (28, 32), and in which a plurality of load current paths (18) are additionally arranged, each of which is secured via a fuse element (26), each of which is configured to connect with an electrical line (22).

## Revendications

1. Dispositif de commutation électrique (2) conçu en particulier pour un véhicule automobile et comportant
- une plaque de conduction (34) présentant une face supérieure (36) et présentant une face inférieure (56), la plaque de conduction (34) s'étendant dans une direction longitudinale (6) et une direction transversale (8),
- au moins un commutateur électronique de puissance (38) qui est appliqué sur la face supérieure (36) de la plaque de conduction (34), ainsi
- qu'une première barre de distribution (32) qui s'étend en direction longitudinale (6) et est reliée de façon électriquement conductrice audit au moins un commutateur de puissance (38),
dans lequel
- la première barre de distribution (32) est disposée sur la face supérieure (36) de la plaque de conduction (34) et présente une zone médiane (44) qui s'étend au-dessus dudit au moins un commutateur électronique de puissance (38), et
- la première barre de distribution (32) est reliée de façon thermiquement conductrice audit au moins un commutateur de puissance (38),
**caractérisé en ce que**
- sur la face inférieure (56) de la plaque de conduction (34) est disposée une seconde barre de distribution (28) qui est également reliée de façon électriquement conductrice audit au moins un commutateur électronique de puissance (38), et
- la seconde barre de distribution (28) est également reliée de façon thermiquement conductrice audit au moins un commutateur de puissance (38).

2. Dispositif de commutation électrique (2) selon la revendication 1,
**caractérisé en ce que** la première barre de distribution (32) est reliée de façon thermiquement conductrice, par l'intermédiaire d'un élément thermoconducteur (62), audit au moins un commutateur de puissance (38).

3. Dispositif de commutation électrique (2) selon la revendication 2,
**caractérisé en ce que** plusieurs commutateurs électroniques de puissance (38) sont, en direction longitudinale (6), disposés les uns à côtés des autres sur la face supérieure (36) de la plaque de conduction (34) et **en ce que** la première barre de distribution (32) est reliée de façon thermiquement conductrice à chaque commutateur électronique de puissance (38), en particulier par l'intermédiaire de l'élément thermoconducteur (62),

4. Dispositif de commutation électrique (2) selon l'une quelconque des revendications 2 et 3,
**caractérisé en ce que** dans la zone dudit au moins un commutateur électronique de puissance (38) la première barre de distribution (32) est incorporée dans l'élément thermoconducteur (62).

5. Dispositif de commutation électrique (2) selon l'une quelconque des revendications 2 à 4,
**caractérisé en ce que** l'élément thermoconducteur (62) est constitué par une matière de remplissage totalement durcie.

6. Dispositif de commutation électrique (2) selon l'une quelconque des revendications 2 à 5,
**caractérisé en ce que** l'élément thermoconducteur (62) s'étend seulement jusqu'à la face supérieure de la plaque de conduction (34), de sorte que cette dernière n'est pas incorporée dans l'élément thermoconducteur (62).

7. Dispositif de commutation électrique (2) selon l'une quelconque des revendications 2 à 6,
**caractérisé en ce que** l'élément thermoconducteur (62) présente une conductivité thermique qui est supérieure à 0,15 W/mK et en particulier supérieure à 0,8 W/mK.

8. Dispositif de commutation électrique (2) selon l'une quelconque des revendications précédentes,
**caractérisé en ce que** latéralement à la zone médiane (44) fait suite au moins un bras de jonction (50) par l'intermédiaire duquel la première barre de distribution (32) est raccordée à la plaque de conduction (34), ledit au moins un bras de jonction (50), vu en direction transversale (8), étant passé devant le commutateur électronique de puissance (38) latéralement à côté du commutateur électronique de puissance (38).

9. Dispositif de commutation électrique (2) selon la revendication 8,
**caractérisé en ce que** vu en direction transversale (8) à la zone médiane (44) fait suite sur chacun des deux côtés au moins un bras de jonction (50), de sorte que la zone médiane (44) et les bras de jonction (50) forment - dans une projection de la première barre de distribution (32), vu en direction longitudinale (6) - une structure en forme d'U.

10. Dispositif de commutation électrique (2) selon l'une quelconque des revendications 8 et 9 et selon l'une quelconque des revendications 2 à 7,
**caractérisé en ce que** l'élément thermoconducteur (62) remplit en totalité un espace intermédiaire (64) qui est limité d'un côté par la zone médiane (44) et de préférence en outre d'un autre côté par ledit au moins un bras de jonction (50).

11. Dispositif de commutation électrique (2) selon l'une quelconque des revendications 1 à 10,
**caractérisé en ce que** la seconde barre de distribution (28) est raccordée à une entrée de puissance et la première barre de distribution (32) est raccordée à une sortie de puissance dudit au moins un commutateur de puissance (38).

12. Dispositif de commutation électrique (2) selon l'une quelconque des revendications 1 à 11,
**caractérisé en ce que** la plaque de conduction (34) comporte dans la zone dudit au mois un commutateur de puissance (38) une ouverture traversante (58) et la seconde barre de distribution (28) comporte un tenon (60) et **en ce que** le tenon (60) est au moins partiellement introduit dans l'ouverture traversante (58), de sorte que la seconde barre de distribution (28) est fixée en particulier par pression sur la plaque de conduction (34).

13. Dispositif de commutation électrique (2) selon l'une quelconque des revendications 1 à 12,
**caractérisé en ce que** la seconde barre de distribution (28) est configurée en tant qu'entrée de puissance pour un raccordement à une source de courant, en particulier un accumulateur de véhicule automobile, et **en ce que** la première barre de distribution (32) est configurée en tant que sortie de puissance pour un raccordement à au moins un consommateur.

14. Dispositif de commutation électrique (2) selon l'une quelconque des revendications 1 à 13,
**caractérisé en ce que** ce dernier est configuré en tant qu'une boîte à fusibles (2) pour un véhicule automobile, dans laquelle la plaque de conduction (34) conjointement avec les commutateurs de puissance (38) appliqués sur celle-ci, forment avec les deux barres de distribution (28, 32) une unité électronique de sécurité (24) et dans laquelle sont en outre disposées plusieurs voies de courant de charge (18) sécurisées chacune par un élément de sécurité (26), qui sont configurées chacune pour le raccordement à une ligne électrique (22).
